# DEMANDE DE BREVET EUROPEEN

(11) **EP 2 551 899 A1**
(43) Date de publication de la demande: **30.01.2013**
(21) Numéro de dépôt: 12177539.9
(22) Date de dépôt: 23.07.2012
(51) Int. Cl.: H01L 21/762, H01L 21/311

(54) **Procédé ameliore de réalisation de tranchées d'isolation dans un substrat semi-conducteur sur isolant**

(30) Priorité: 27.07.2011 FR 1156854
(71) Demandeur: Commissariat à l'Énergie Atomique et aux Énergies Alternatives, 75015 Paris (FR)
(72) Inventeur: Le Tiec, Yannick, 38920 Crolles (FR); Grenouillet, Laurent, 38140 Rives (FR); Vinet, Maud, 38140 Rives (FR)
(74) Mandataire: Ilgart, Jean-Christophe

(57) **Abrégé**

La présente invention concerne un procédé de réalisation d'une ou plusieurs tranchées dans un dispositif comprenant un substrat de type semi-conducteur sur isolant formé d'une couche semi-conductrice de support, d'une couche isolante reposant sur la couche de support, et d'une couche semi-conductrice reposant sur ladite couche isolante, le procédé comprenant des étapes de :
a) dopage localisé d'une portion donnée de ladite couche isolante à travers une ouverture d'une couche de masquage reposant sur la fine couche semi-conductrice,
b) retrait sélectif de ladite zone donnée dopée au fond de ladite ouverture.

## Description

### DOMAINE TECHNIQUE

La présente invention se rapporte au domaine des dispositifs microélectroniques dotés de tranchées d'isolation réalisées dans un substrat de type semi-conducteur sur isolant, notamment de type SOI (SOI pour « silicon on insulator » ou « silicium sur isolant »).

Elle concerne un procédé de réalisation de tranchées d'isolation entre des éléments ou des régions d'un dispositif microélectronique, dans lequel un contrôle précis de la profondeur des tranchées est mis en oeuvre.

Elle peut s'appliquer notamment à la réalisation de dispositifs nécessitant des tranchées d'isolation traversant la couche de support semi-conductrice d'un substrat semi-conducteur sur isolant ayant des profondeurs identiques.

### ÉTAT DE LA TECHNIQUE ANTÉRIEURE

Pour isoler entre eux des éléments d'un dispositif microélectronique par exemple des composants ou des ensembles de composants, et empêcher des fuites de courant entre ces éléments, il est connu de réaliser des tranchées isolantes dites de surface, communément appelées STI (STI pour « shallow trench isolation ») dans un substrat.

La réalisation de zones d'isolation STI peut être effectuée préalablement à la mise en oeuvre de transistors et peut comprendre des étapes de gravure d'un substrat de manière à former des trous, puis remplissage des trous à l'aide d'un matériau diélectrique tel que par exemple du SiO₂.

Pour certaines applications, on doit réaliser des tranchées d'isolation dites « profondes » (deep STI selon la terminologie anglo-saxonne).

Les documents US 2008/0213971 A1 et US 2011/0057287 A1 divulguent une réalisation sur un même substrat, de tranchées isolantes de profondeurs différentes.

Le contrôle de la profondeur des tranchées peut s'avérer déterminant.

Lorsqu'on réalise des tranchées d'isolation 19 de surface dans un substrat semi-conducteur sur isolant comprenant une couche de support semi-conductrice 10 par exemple à base de Si, recouverte par une couche isolante 11 par exemple d'oxyde enterré, elle-même recouverte par une fine couche semi-conductrice 12 par exemple à base de Si, on peut chercher à vouloir placer le fond de ces tranchées au niveau de l'interface 13 entre la couche isolante 11 et la couche semi-conductrice 10.

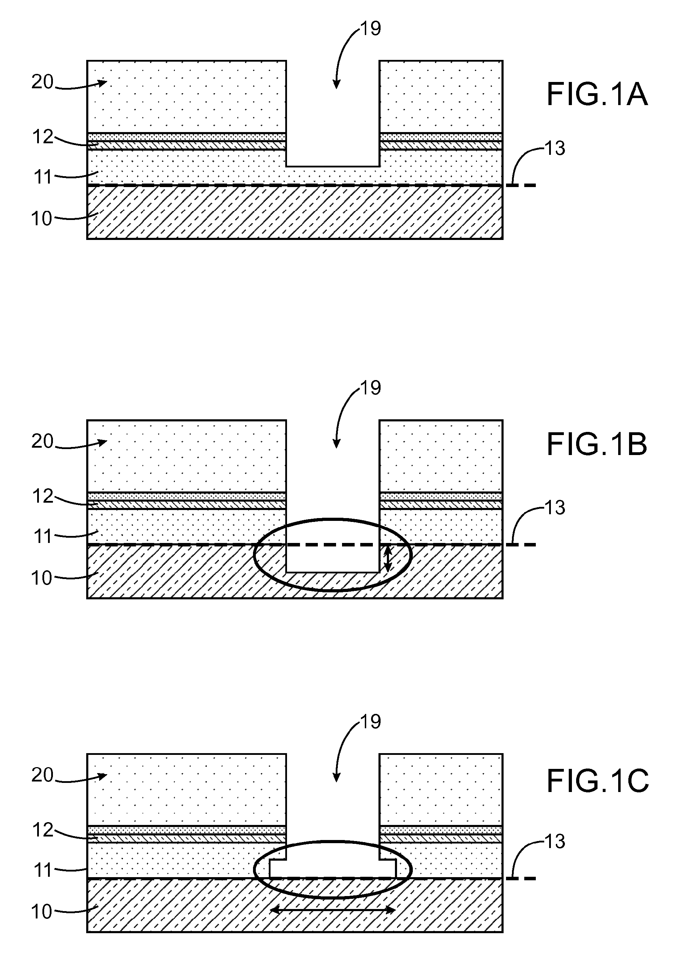

La maitrise de la profondeur de telles tranchées pose problème, comme le montre les exemples de réalisation des figures 1A-1C.

Sur la figure 1A, les tranchées 19 de surface ont été réalisées par gravure à travers un masquage 20, et traversent la fine couche semi-conductrice 12 ainsi qu'une partie de la couche isolante 11. Dans cet exemple, les tranchées 19 n'atteignent pas l'interface 13 entre la couche isolante 11 et la couche semi-conductrice 10 et s'arrêtent sur une épaisseur restante de la couche isolante 11.

Cette épaisseur restante peut poser problème notamment dans le cas où l'on souhaite par la suite réaliser des tranchées d'isolation profondes 19.

Sur l'exemple de la figure 1B, les tranchées 19 ont été réalisées de manière à dépasser l'interface 13 entre la couche isolante 11 et la couche semi-conductrice 10 et traverser une épaisseur restante de la couche semi-conductrice 10 de support.

Des tranchées d'isolation trop profonde peuvent, dans certains dispositifs, entrainer une augmentation de la résistance électrique des zones de la couche semi-conductrice 10 de support, ce qui peut s'avérer nuisible en particulier lorsque ces zones appartiennent à une région de puit N (« N-Well » selon la terminologie anglo-saxonne) ou à une région de plan de masse.

Pour réaliser des tranchées 19 qui s'arrêtent précisément à l'interface 13, on peut réaliser une gravure du matériau de la couche isolante par exemple du SiO₂, sélective vis-à-vis de la couche semi-conductrice de support 10 qui peut être par exemple à base de Si.

Cependant, cette gravure sélective a tendance à se poursuivre dans des zones de la couche isolante 11 qui n'étaient pas prévues pour être retirées. Sur la figure 1C, une surgravure de la couche isolante 11 est illustrée. Les tranchées 19 réalisées ont un fond évasé traduisant une gravure excessive de la couche isolante 11.

Cela peut rendre plus difficile le remplissage des tranchées par un matériau diélectrique.

Il se pose le problème de trouver un nouveau procédé de réalisation de tranchées isolantes qui ne présente pas les inconvénients mentionnés ci-dessus.

### EXPOSÉ DE L'INVENTION

L'invention concerne tout d'abord un procédé de réalisation d'une ou plusieurs tranchées dans un substrat de type semi-conducteur sur isolant formé d'une couche semi-conductrice de support, d'une couche isolante reposant sur ladite couche de support et à base d'un matériau diélectrique donné, et d'une couche semi-conductrice reposant sur ladite couche isolante.

Ce procédé peut comprendre des étapes de :
a) dopage localisé d'une portion donnée de ladite couche isolante à travers une ouverture d'une couche de masquage reposant sur la fine couche semi-conductrice,
b) retrait sélectif de ladite zone donnée dopée au fond de ladite ouverture.

Ce retrait sélectif est effectué par gravure sélective de ladite zone dopée vis-à-vis du matériau diélectrique donné de ladite couche isolante.

La gravure est également sélective vis-à-vis de la couche semi-conductrice de support.

Ainsi, grâce ces sélectivités de gravure on peut former au moins une tranchée dont le fond s'arrête précisément à l'interface entre la couche isolante et la couche semi-conductrice de support.

Préalablement à l'étape a), une étape de gravure anisotrope d'une épaisseur de la couche isolante à travers au moins une ouverture d'une couche de masquage reposant sur la fine couche semi-conductrice peut être réalisée. La portion donnée correspond à une épaisseur restante de ladite couche isolante conservée au fond de ladite ouverture suite à cette gravure anisotrope.

En effectuant cette gravure anisotrope préalablement à l'étape a), on réduit tout d'abord l'épaisseur de la portion de couche isolante située au fond de l'ouverture sans risquer de réduire d'autres parties de cette couche isolante situées sous la couche de masquage. Puis, l'étape b) de retrait sélectif permet de retirer la portion restante de la couche isolante située au fond de l'ouverture en s'arrêtant précisément au niveau de l'interface entre la couche isolante et la couche de support.

Lors de l'étape b), les parois de l'ouverture peuvent être recouvertes par des zones de protection. Ces zones de protection peuvent avoir été réalisées dans un matériau donné choisi de sorte que la couche isolante peut être gravée sélectivement vis-à-vis de ce matériau donné.

Les zones de protection peuvent avoir été formées par :
- dépôt d'une couche de protection dans ladite ouverture,
- dopage sélectif de la couche de protection de sorte qu'une région située au fond de ladite ouverture est dopée,
- retrait des régions dopées de ladite couche de protection.

L'invention concerne également la réalisation de tranchées isolantes profondes.

Ainsi, le procédé peut comprendre en outre après l'étape b), la gravure de la couche de support semi-conductrice dans le prolongement de ladite ouverture.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A, 1B, et 1C illustrent différentes réalisations de tranchées d'isolation à travers un substrat de type semi-conducteur sur isolant,
- les figures 2A-2G illustrent un exemple de procédé suivant l'invention, de réalisation de tranchées d'isolation à travers un substrat de type semi-conducteur sur isolant,
- les figures 3A-3C illustrent un autre exemple de procédé suivant l'invention, de réalisation de tranchées d'isolation à travers un substrat de type semi-conducteur sur isolant,
- les figures 4A-4C illustrent un exemple de procédé de réalisation de tranchées d'isolation profondes traversant partiellement la couche semi-conductrice de support d'un substrat de type semi-conducteur sur isolant,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

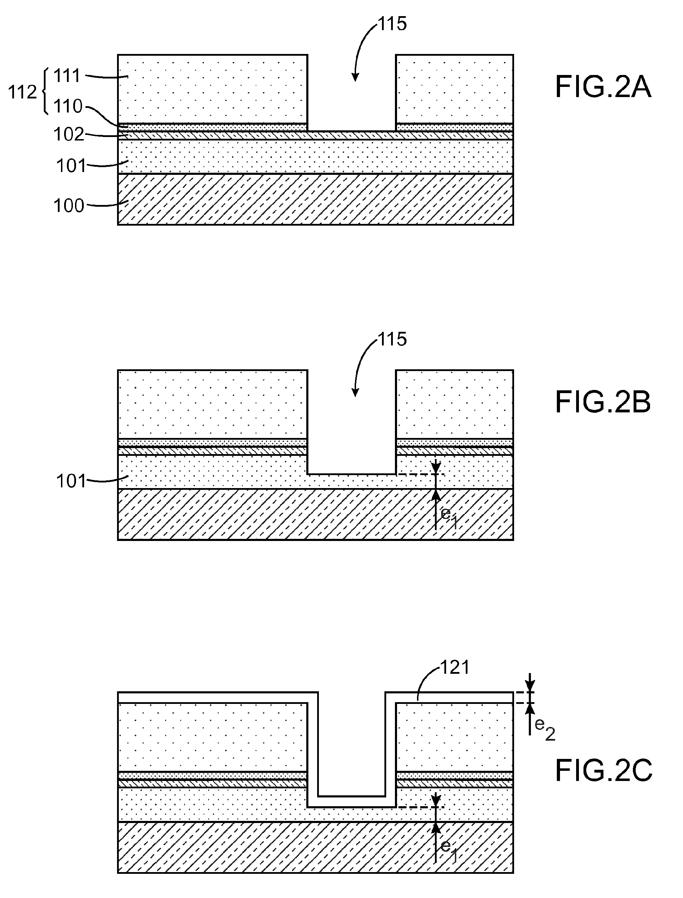

Un exemple de procédé de réalisation de tranchées isolantes suivant l'invention, va à présent être décrit en liaison avec les figures 2A-2G.

Le matériau de départ de ce procédé est un substrat de type semi-conducteur sur isolant, qui peut être de type SOI, et comprend une couche de support semi-conductrice 100 par exemple à base de Si, recouverte par une couche isolante 101 par exemple de SiO₂, surmontée d'une fine couche semi-conductrice 102 par exemple à base de Si. Par « fine » couche semi-conductrice on entend une couche semi-conductrice d'épaisseur inférieure à 100 nanomètres, par exemple d'épaisseur comprise entre 2 et 100 nanomètres ou de l'ordre de 10 ou 20 nanomètres.

La couche isolante 101 peut, quant à elle, avoir une épaisseur x comprise par exemple entre 25 et 150 nanomètres.

On forme tout d'abord un masquage 112 recouvrant la fine couche semi-conductrice 102.

Ce masquage 112 peut être isolant et formé par exemple d'un empilement de couches de matériaux diélectriques, avec, par exemple, une première fine couche diélectrique 110 à base de SiO₂, recouverte par une deuxième couche diélectrique 111 à base d'un matériau diélectrique différent, par exemple du Si₃N₄, recouvrant la première fine couche diélectrique 110. Le masquage 112 peut être réalisé de manière à comporter au moins une ouverture 115 dévoilant la fine couche semi-conductrice 102 (figure 2A).

On effectue ensuite, à travers l'ouverture 115, une gravure de la fine couche semi-conductrice 102, puis d'une épaisseur donnée de la couche isolante 101, de manière à prolonger l'ouverture 115 qui débouche alors sur la couche isolante 101.

Cette gravure peut être anisotrope. Un tel type de gravure permet de prolonger l'ouverture 115 sans l'élargir. La gravure anisotrope peut être par exemple une gravure sèche réalisée par exemple par gravure ionique réactive communément appelée RIE (RIE pour « Reactive Ion Etching »). La gravure est réalisée de manière à conserver une épaisseur donnée e₁ de la couche isolante 101, qui peut être par exemple comprise entre 20% et 80% de son épaisseur initiale, ou comprise par exemple entre 5 nanomètres et 20 nanomètres (figure 2B).

Suite à cette gravure partielle de la couche isolante 101, une portion 101a d'épaisseur donnée e₁ par exemple égale à la moitié x/2 de l'épaisseur x de la couche isolante 101, est conservée au fond de l'ouverture 115.

Puis, on forme une couche 121 dite « de protection » d'épaisseur e₂, comprise par exemple entre 3 nanomètres et 5 nanomètres, recouvrant notamment les parois verticales ainsi que le fond de l'ouverture 115, la portion de la couche isolante 111 située au fond de l'ouverture 115 étant recouverte par cette couche de protection 121 (figure 2C).

La couche 121 de protection peut être choisie par exemple à base d'un matériau différent de celui de la couche isolante 101, et en particulier à base d'un matériau qui peut être gravé de manière sélective vis-à-vis du matériau de la couche isolante 101. La couche 121 de protection peut être par exemple à base de Si₃N₄.

On effectue ensuite un dopage de la couche de protection 121, en particulier d'une région 121a de cette dernière située au fond de l'ouverture 115. Des régions de la couche de protection situées de part et d'autre de l'ouverture 115 et reposant sur le masquage 112, sont également dopées.

Ce dopage peut être réalisé par au moins une implantation ionique, par exemple à l'aide de H, et/ou de He, et/ou d'Ar.

Un dopage de la portion 101a restante de la couche isolante 101 située au fond de l'ouverture 115 sous la couche de protection 121 est également effectué éventuellement lors de l'étape d'implantation de la région 121a ou lors d'une autre étape.

Ce dopage peut être également effectué, à l'aide d'au moins une implantation ionique, par exemple à l'aide de H, et/ou de He, et/ou d'Ar.

Pour doper la portion 101a de la couche isolante située au fond du trou 119, plusieurs implantations successives peuvent être effectuées.

Une première implantation par exemple à l'aide d'Ar, selon une dose par exemple de 5*10¹⁵ et selon par exemple une énergie de l'ordre de 3 keV, suivie d'une deuxième implantation par exemple à l'aide d'Ar, selon une dose par exemple de 5*10¹⁵ et selon une énergie par exemple de l'ordre de 15 keV, peut être effectuée afin d'implanter une couche de protection 121 à base de nitrure d'épaisseur par exemple de l'ordre de 9 nm, ainsi qu'une portion 101a de la couche isolante d'épaisseur par exemple de l'ordre de 10 à 15 nanomètres.

Ensuite, on effectue un retrait partiel de la couche de protection 121. Ce retrait peut être réalisé par gravure sélective de manière à supprimer des régions de la couche de protection 121 qui ont été dopées, tout en conservant des régions 121b, 121c de cette couche de protection 121 qui n'ont pas été dopées.

Les régions 121b, 121c de la couche de protection 121 conservées tapissent une partie des parois verticales de l'ouverture 115, et en particulier recouvrent des zones de la fine couche semi-conductrice 102 et du masquage 112 dans l'ouverture 115.

Un retrait de la portion 101a restante de la couche isolante 101 située au fond de l'ouverture 105, peut être réalisé par gravure sélective vis-à-vis du matériau de la couche de support 100, tandis que la fine couche semi-conductrice 102 et le masquage 112 sont protégés par les régions 121b, 121c de la couche de protection 121.

Du fait du dopage de la portion restante 101a de la couche isolante 101 tandis que le reste de cette couche isolante 101 n'est pas dopé, une sélectivité de gravure entre cette portion 101a et le reste de la couche isolante 101 est également opéré.

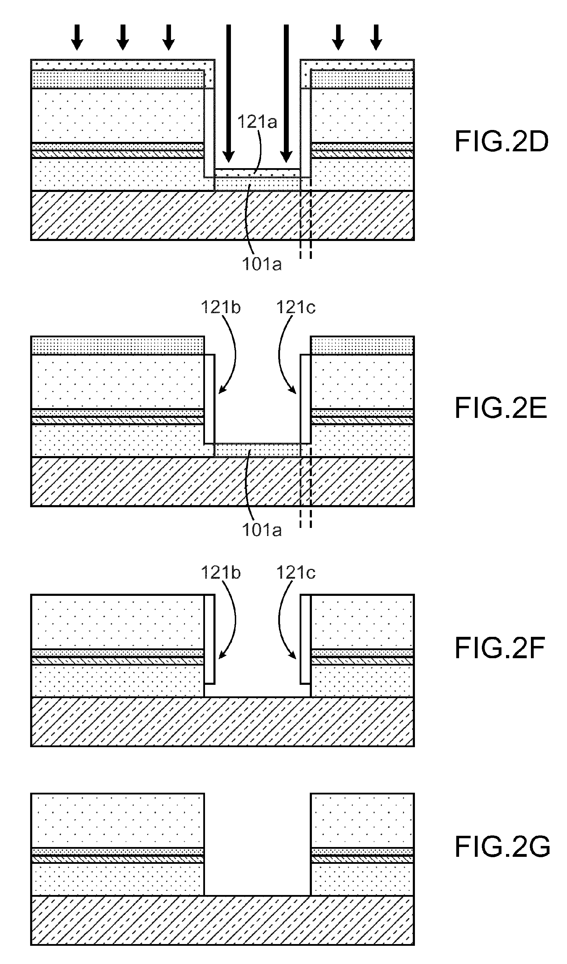

Cette sélectivité peut être par exemple de 4/1, de sorte que les parties non-dopées de la couche isolante 101 se consomment 4 fois plus lentement que la portion 101a dopée (figure 2F).

La gravure de la portion 101a restante de la couche isolante 101 peut être effectuée par exemple à l'aide de HF, par exemple au moyen d'une solution de gravure communément appelée BOE (BOE pour « buffered oxide etch ») composée d'un tampon, comme du fluorure d'ammonium (NH₄F), et d'acide fluorhydrique (HF). Cette gravure peut conduire au retrait de zones de la couche isolante 101 situées à l'aplomb des régions 121a, 121b de la zone de protection.

Ensuite, un retrait des régions 121a, 121b de protection est réalisé, par exemple à l'aide de H₃PO₄ (figure 2G).

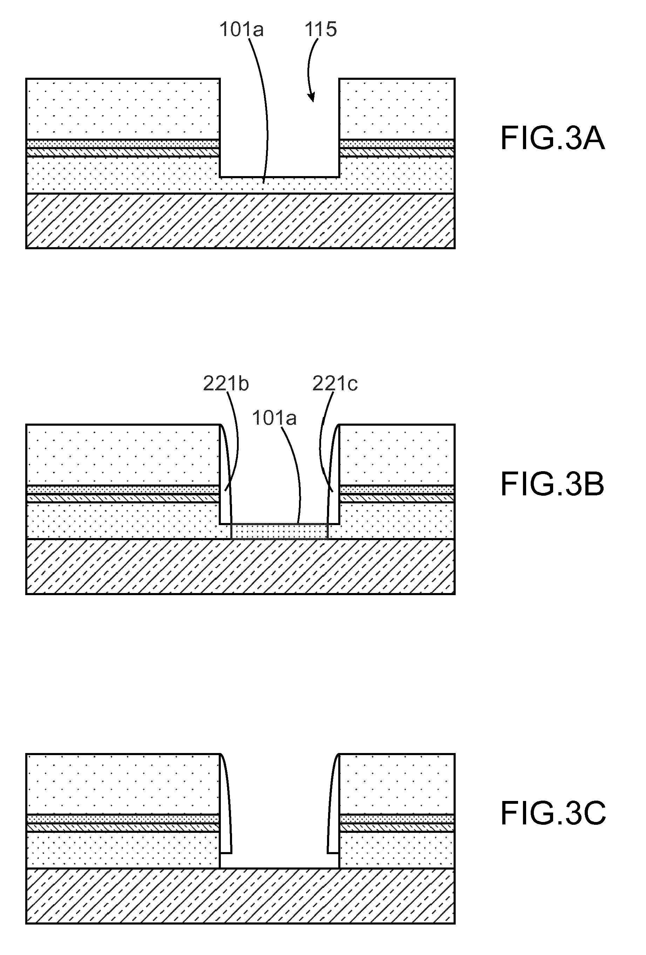

Une variante de réalisation est illustrée sur les figures 3A-3C.

Comme pour l'exemple de procédé précédemment décrit, on peut former un masquage 112 sur la fine couche semi-conductrice 102, puis réaliser au moins une ouverture 115 dans ce masquage 112.

On grave ensuite partiellement la couche isolante 101 au fond de l'ouverture, en conservant une portion 101a de la couche isolante 101 (figure 3A).

On forme ensuite la couche de protection 121. Une gravure anisotrope de cette couche de protection 121 peut être ensuite gravée, par exemple à l'aide d'une gravure RIE (RIE pour « Reactive Ion Etching »). Cette gravure est réalisée de manière à conserver des régions 221b, 221c tapissant les parois verticales de l'ouverture 115, la portion 101a étant dévoilée au fond de l'ouverture 115 (figure 3B).

Cette gravure peut présenter une sélectivité entre le matériau de la couche de protection 121 et celui de la couche isolante 101.

Puis, on réalise un dopage de la portion 101a dévoilée au fond de l'ouverture 115.

Ensuite, on effectue un retrait de la portion restante 101a de la couche isolante 101 par gravure sélective vis-à-vis du reste de la couche isolante 101 (figure 3C). Cette gravure isolante 101 peut être par exemple une gravure sélective.

L'un ou l'autre des exemples de procédé décrits en liaison avec les figures 2 et 3 peuvent être utilisés au cours d'un procédé visant à réaliser des tranchées isolantes de profondeurs différentes.

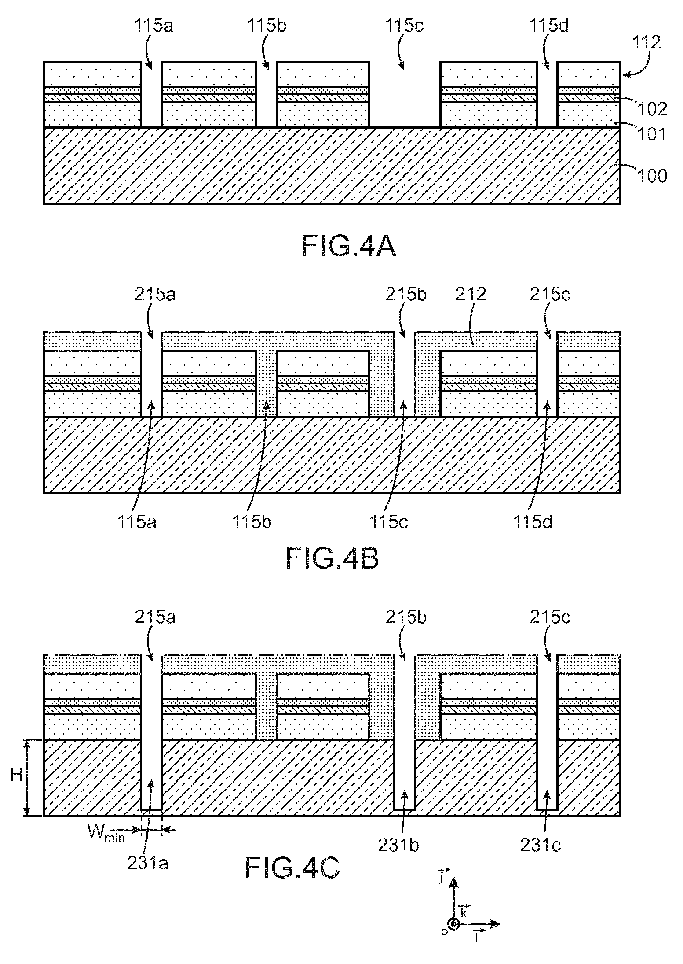

Un autre exemple de procédé suivant l'invention va à présent être donné en liaison avec les figures 4A-4C.

Comme dans l'un ou l'autre des exemples de procédés précédemment décrits, on forme tout d'abord un premier masquage 112 recouvrant la fine couche semi-conductrice 102 d'un substrat semi-conducteur sur isolant, le masquage 112 comportant des ouvertures 115a, 115b, 115c, 115d dévoilant la fine couche semi-conductrice 102.

Puis, à travers les ouvertures 115a, 115b, 115c, 115d, une gravure de la fine couche semi-conductrice 102, puis d'une épaisseur donnée de la couche isolante 101, est effectuée par gravure anisotrope à travers les ouvertures 115a, 115b, 115c, 115d, de manière à conserver une épaisseur donnée de la couche isolante 101.

Puis, comme dans les exemples de procédé décrits précédemment, on effectue un dopage de l'épaisseur donnée de la couche isolante 101a, que l'on grave ensuite de manière sélective vis-à-vis du reste de la couche isolante 101. Cette gravure est stoppée lorsque cette épaisseur est retirée et que l'on a atteint l'interface entre la couche isolante 101 et la couche de support 100.

On obtient ainsi, une uniformité entre les profondeurs respectives des ouvertures 115a, 115b, 115c, 115d.

Ensuite, on forme un deuxième masquage 212 par dessus le premier masquage 112. Ce deuxième masquage 212 peut être, par exemple, un masquage à base de résine photosensible et comporte des trous 215a, 215b, 215c, dévoilant chacun une ouverture parmi lesdites ouvertures 115a, 115c, 115d, formées dans le premier masquage 112. Le deuxième masquage 212 peut être réalisé de manière à combler au moins une ouverture 115b parmi les ouvertures du premier masquage (figure 4B).

Puis, on réalise des tranchées 230a, 230b, 230c à travers les trous 215a, 215b, 215c du deuxième masquage 212. Pour cela, on effectue une gravure de l'épaisseur restante de la couche isolante 101 située au fond des trous 215a, 215b, 215c, ainsi que de la couche semi-conductrice 100 de support dans le prolongement des ouvertures 115a, 115c, 115d. Cette gravure peut être réalisée par exemple à base de HBr/O₂. Des tranchées profondes 231a, 231b, 231c, traversant une partie de l'épaisseur de la couche de support 100 sont ainsi réalisées (figure 4C). Ces tranchées profondes 231a, 231b, 231c, peuvent avoir une largeur ou dimension critique Wmin (la dimension critique ou largeur des tranchées étant leur plus petite dimension mesurée dans un plan parallèle au plan [O*;i̅;k̅*] du repère orthogonal [O*;i̅;j̅;k̅*]) comprise par exemple, entre 30 et 100 nanomètres, ou par exemple de l'ordre de 50 nanomètres. Les tranchées profondes 231a, 231b, 231c peuvent également avoir une profondeur H comprise par exemple entre 50 nanomètres et 5 micromètres ou entre 50 nanomètres et 500 nanomètres, par exemple de 180 ou 200 nanomètres.

L'uniformité de profondeur entre les ouvertures 115a, 115b, 115d réalisées lors d'étape décrites précédemment en liaison avec la figure 4A permet d'obtenir également une uniformité de profondeur entre les tranchées 231a, 231b, 231c traversant la couche de support 100.

On peut ensuite effectuer un remplissage des tranchées à l'aide d'un matériau diélectrique.

## Revendications

1. Procédé de réalisation d'une ou plusieurs tranchées dans un dispositif comprenant un substrat de type semi-conducteur sur isolant formé d'une couche semi-conductrice de support (100), d'une couche isolante (101) reposant sur la couche de support, et d'une couche semi-conductrice (102) reposant sur ladite couche isolante (101), le procédé comprenant des étapes de :
a) dopage localisé d'une portion donnée (101a) de ladite couche isolante (101) à travers une ouverture (115, 115b) d'une couche de masquage (112) reposant sur la fine couche semi-conductrice (102),
b) retrait par gravure sélective de ladite zone donnée dopée au fond de ladite ouverture.

2. Procédé selon la revendication 1, comprenant préalablement à l'étape a), une étape de gravure anisotrope d'une épaisseur de la couche isolante à travers au moins une ouverture (115, 115b) d'une couche de masquage (112) reposant sur la fine couche semi-conductrice, ladite portion donnée correspondant à une épaisseur restante de ladite couche isolante (101) conservée au fond de ladite ouverture correspondante.

3. Procédé selon la revendication 1 ou 2, dans lequel, lors de l'étape b), les parois de l'ouverture sont protégées par des zones de protection (121b, 121c).

4. Procédé selon la revendication 3, les zones de protection ayant été formées par :
- dépôt d'une couche de protection dans ladite ouverture (115) ,
- dopage sélectif de la couche de protection au moins une région située au fond de ladite ouverture étant dopée,
- retrait des régions dopées de ladite couche de protection.

5. Procédé selon l'une des revendications 1 à 4, comprenant en outre après l'étape b), la gravure de la couche de support semi-conductrice dans le prolongement de ladite ouverture.
